# EUROPÄISCHE PATENTSCHRIFT

(11) **EP 2 727 155 B1**
(45) Veröffentlichungstag und Bekanntmachung des Hinweises auf die Patenterteilung: **07.08.2019**
(21) Anmeldenummer: 12745645.7
(22) Anmeldetag: 26.06.2012
(51) Int. Cl.: H01L 31/18

(54) **VERFAHREN ZUR SCHNELLEN STABILISIERUNG DER NENNLEISTUNG EINES DÜNNSCHICHTSOLARMODULS**
METHOD FOR QUICKLY STABILIZING THE NOMINAL OUTPUT OF A THIN-FILM SOLAR MODULE
PROCÉDÉ DE STABILISATION RAPIDE DU RENDEMENT NOMINAL D'UN MODULE SOLAIRE EN COUCHES MINCES

(30) Priorität: 28.06.2011 EP 11171706
(43) Veröffentlichungstag der Anmeldung: 07.05.2014
(73) Patentinhaber: (CNBM) Bengbu Design & Research Institute for Glass Industry Co., Ltd., Bengbu (CN)
(72) Erfinder: AVELLAN, Alejandro, 50937 Köln (DE); GRÜNERBEL, Manfred, 80992 München (DE)
(74) Vertreter: Gebauer, Dieter Edmund
(86) Internationale Anmeldenummer: PCT/EP2012/062323
(87) Internationale Veröffentlichungsnummer: WO 2013/000894

(56) Entgegenhaltungen:
- EP-A1- 2 023 400
- WO-A2-2009/133163
- J. A. DEL CUETO ET AL: "Striving for a standard protocol for preconditioning or stabilization of polycrystalline thin film photovoltaic modules", PROCEEDINGS OF SPIE, 1. Januar 2009 (2009-01-01), Seite 741204, XP055025713, DOI: 10.1117/12.825380

## Beschreibung

Die Erfindung liegt auf dem technischen Gebiet der photovoltaischen Energieerzeugung und betrifft ein Verfahren zur schnellen Stabilisierung der Nennleistung bzw. des Wirkungsgrads eines Dünnschichtsolarmoduls.

Photovoltaische Schichtensysteme zur direkten Umwandlung von Sonnenlicht in elektrische Energie sind hinlänglich bekannt. Flächig ausgedehnte Schichtensysteme werden gewöhnlich als "Solarzellen" bezeichnet. Der spezielle Begriff "Dünnschichtsolarzellen" bezeichnet photovoltaische Schichtensysteme mit Dicken von nur wenigen Mikrometern. Dünnschichtsolarzellen benötigen Trägersubstrate zur Bereitstellung einer ausreichenden mechanischen Festigkeit. Bekannte Trägersubstrate umfassen anorganisches Glas, Kunststoffe (Polymere) oder Metalle, insbesondere Metalllegierungen, und können in Abhängigkeit von der jeweiligen Schichtdicke und den spezifischen Materialeigenschaften als starre Platten oder biegsame Folien ausgestaltet sein. Aufgrund der weitreichend verfügbaren Trägersubstrate und einer einfachen monolithischen Integration können großflächige Anordnungen von Dünnschichtsolarzellen kostengünstig hergestellt werden, wobei die Halbleiterschicht in der Regel direkt auf das Trägersubstrat, beispielsweise Glas, aufgebracht wird. Hinsichtlich der technologischen Handhabbarkeit und des Wirkungsgrads haben sich Dünnschichtsolarzellen mit einer Halbleiterschicht aus amorphem, mikromorphem oder polykristallinem Silizium, Cadmium-Tellurid (CdTe), Gallium-Arsenid (GaAs) oder einer Chalkopyrit-Verbindung, insbesondere Kupfer-Indium/Gallium-Schwefel/Selen (CI(In,Ga) (S, Se)₂), als vorteilhaft erwiesen, wobei sich insbesondere Kupfer-Indium-Diselenid (CuInSe₂ bzw. CIS) aufgrund seines an das Spektrum des Sonnenlichts angepassten Bandabstands durch einen hohen Absorptionskoeffizienten auszeichnet.

Um eine technisch brauchbare Ausgangsspannung zu erhalten, werden in der Regel viele Solarzellen seriell verschaltet, wobei die insbesondere auf ein Trägersubstrat aufgebrachten Solarzellen üblicherweise mit einer vorderseitigen transparenten Deckschicht, insbesondere Deckplatte, und zumindest einer haftvermittelnden Klebefolie zu einem bewitterungsstabilen Photovoltaik- bzw. Solarmodul verbunden werden ("Laminierung"). Für das Material der Deckschicht wird beispielsweise eisenarmes Natron-Kalk-Glas gewählt. Die haftvermittelnde Klebefolie besteht beispielsweise aus Ethylenvinylacetat (EVA), Polyvinylbutyral (PVB), Polyethylen (PE), Polyethylenacrylcopolymer oder Polyacrylamid (PA). EVA zeichnet sich als vernetzbares gummielastisches Material durch eine besonders gute Verarbeitbarkeit aus und wird deshalb häufig eingesetzt. Bei Dünnschichtsolarmodulen mit Verbundscheibenstruktur wurde in den letzten Jahren zunehmend PVB eingesetzt. PVB gehört zu den Thermoplasten, die unter Hitzeeinwirkung aufschmelzen, ohne dabei zu vernetzen und sich in der chemischen Zusammensetzung nicht verändern.

Nun können bei der Herstellung von Solarmodulen verschiedenartige Defekte auftreten, welche in nachteiliger Weise interne elektrische Leistungsverluste bewirken und somit die Nennleistung bzw. Wirkungsgrad von Solarmodulen vermindern. Beispiele hierfür sind Kurzschlüsse (Shunts), die zu einer lokal erhöhten Rekombinationsrate von Ladungsträgern, mechanische Defekte wie Risse, Brüche und Delaminierungen oder Variationen der Materialqualität führen.

Bei manchen Solarmodulen kann in besonders nachteiliger Weise eine zumindest weitgehend reversible (transiente) Verringerung der Nennleistung durch den Laminierungsprozess auftreten. Ohne auf eine Theorie eingeschränkt zu sein, wird angenommen, dass durch die Einwirkung von Hitze, Druck und Feuchte beim Laminieren Defekte in der Halbleiterschicht erzeugt werden, die im Laufe der Zeit zumindest teilweise, in der Regel jedoch weitestgehend, wieder ausheilen. Wie Versuche gezeigt haben, haben Dünnschichtsolarmodule auf Basis von Chalkopyrit-Halbleitern nach dem Laminieren eine temporär verringerte Nennleistung, die ca. 5-20% niedriger ist als die Nennleistung der Solarzellen vor dem Laminieren.

Für den Hersteller bedeutet dies unter Umständen einen finanziellen Nachteil, da Solarmodule zu einem auf eine vermeintlich geringere Leistung abgestimmten Preis abgesetzt werden. Ist die für ein Solarmodul werksseitig angegebene Nennleistung wesentlich niedriger als die tatsächliche Nennleistung, die sich nach Erholung einstellt, kann dies gegebenenfalls auch zu einer suboptimalen Auslegung des elektrischen Systems einer Solaranlage führen.

Demgegenüber besteht die Aufgabe der vorliegenden Erfindung darin, ein für die Serienfertigung von Dünnschichtsolarmodulen aus einer Chalkopyritverbindung taugliches Verfahren zur schnellen Stabilisierung der Nennleistung zur Verfügung zu stellen, durch das eine durch die Laminierung verursachte (temporäre) Verringerung der Nennleistung der Dünnschichtsolarmodule schon im Werk im Rahmen der üblichen Produktionszyklen zumindest weitgehend beseitigt werden kann. Diese und weitere Aufgaben werden nach dem Vorschlag der Erfindung durch ein Verfahren mit den Merkmalen des unabhängigen Patentanspruchs gelöst. Vorteilhafte Ausgestaltungen der Erfindung sind durch die Merkmale der Unteransprüche angegeben.

Das Dokument WO2009133163 offenbart eine Light-Soak-Behandlung eines CIS-Dünnschichtsolarmoduls nach dem Laminierprozess.

Erfindungsgemäß ist ein Verfahren zur schnellen Stabilisierung der Nennleistung bzw. Wirkungsgrads eines Dünnschichtsolarmoduls gezeigt.

Das Dünnschichtsolarmodul umfasst einen laminierten Verbund aus zwei durch zumindest eine (Kunststoff-)Klebeschicht miteinander verbundenen Substraten, zwischen denen sich seriell verschaltete (Dünnschicht-)Solarzellen befinden. Jede Solarzelle umfasst zumindest eine, einen Hetero- bzw. pn-Übergang, das heißt eine Abfolge von Bereichen mit unterschiedlichem Leitungstyp, bildende Halbleiterschicht. Der laminierte Verbund umfasst typischer Weise zumindest ein (rückseitiges) Trägersubstrat, beispielsweise einen Glasträger, auf den die Solarzellen aufgebracht sind, wobei zu diesem Zweck in der Regel eine erste Elektrodenschicht, eine zweite Elektrodenschicht und zumindest eine zwischen den beiden Elektrodenschichten angeordnete Halbleiterschicht auf das Trägersubstrat aufgebracht sind. Gewöhnlich ist die Halbleiterschicht mit einem Dotierstoff dotiert. Erfindungsgemäß besteht die Halbleiterschicht aus einer Chalkopyritverbindung, bei der es sich insbesondere um einen I-III-VI-Halbleiter aus der Gruppe Kupfer-Indium/Gallium-Dischwefel/Diselenid (Cu(In/Ga)(S/Se)₂), beispielsweise Kupfer-Indium-Diselenid (CuInSe₂ bzw. CIS) oder verwandte Verbindungen, handeln kann. Typischer Weise ist im laminierten Verbund das Trägersubstrat mit den aufgebrachten Solarzellen mittels einer Klebeschicht mit einer für Sonnenlicht möglichst durchlässigen (vorderseitigen) Deckschicht, beispielsweise eine Glasplatte, verklebt, wobei die Solarzellen in die Klebeschicht eingebettet sind.

Die Nennleistung des Dünnschichtsolarmoduls kann in an sich bekannter Weise unter Vorliegen der so genannten Standardtestbedingungen (STC = Standard Test Conditions) der Photovoltaik (Norm IEC 904-3) bestimmt werden. Bei Anwenden der STC wird bei einer Bestrahlungsstärke von 1 kW/m² und einem definierten Spektrum des Sonnenlichts bei einer Modultemperatur von 25°C senkrecht eingestrahlt. Eine Bestrahlungsstärke von 1 kW/m² kann insbesondere auch durch Sonnenlicht (vor allem in südlichen Ländern) erreicht werden.

In dem erfindungsgemäßen Verfahren werden der laminierte Verbund bzw. die verschalteten Solarzellen des Dünnschichtsolarmoduls mit künstlichem Licht zumindest einer Lichtquelle beleuchtet. Dabei ist die Lichtintensität so gewählt, dass der Verbund mit einer Bestrahlungsstärke von mindestens 5 kW/m² (Kilowatt pro Quadratmeter) beleuchtet wird.

Als Bestrahlungsstärke oder Strahlungsstromdichte wird im Sinne vorliegender Erfindung die Leistung der auf die Oberfläche des Verbunds treffenden elektromagnetischen Strahlung verstanden. Wie hier verwendet, bezieht sich der Begriff "Stabilisierung" auf eine Zunahme bzw. Erhöhung der vorübergehend (transient) verringerten Nennleistung (Wirkungsgrad) des laminierten Dünnschichtsolarmoduls durch Ausheilen von beim Laminieren verursachten Defekten in der Halbleiterschicht.

Wie Versuche der Anmelderin gezeigt haben, kann durch Beleuchten der Solarzellen mit einer sehr hohen Bestrahlungsstärke von wenigstens 5 kW/m² in vorteilhafter Weise ein schnelles Ausheilen der durch Laminieren erzeugten Defekte der Solarzellen erreicht werden. Tatsächlich kann bereits durch Beleuchten während eines Zeitraums von wenigen Minuten, beispielsweise im einstelligen Minutenbereich oder kürzer, eine beträchtliche Stabilisierung der Nennleistung des Dünnschichtsolarmoduls bewirkt werden. Die hierdurch erreichte Erhöhung der transient verringerten Nennleistung des Dünnschichtsolarmoduls ist in überraschender Weise nicht oder zumindest nicht wesentlich schlechter als die Erhöhung der Nennleistung, die beispielsweise durch eine Lichtalterung für einen Zeitraum von 48 Stunden unter Standardtestbedingungen (STC) erreicht wird. Erfindungsgemäß kann ein entsprechender Effekt in wesentlich kürzerer Zeit erreicht werden.

Wie die Anmelderin zeigen konnte, ist für eine Zunahme der transient verringerten Nennleistung nicht die Zeitdauer der Beleuchtung entscheidend, sondern vielmehr die hierbei eingesetzte Bestrahlungsstärke. Betrachtet man ein konstantes Produkt aus Bestrahlungsstärke und Beleuchtungszeit, so hat sich in unerwarteter Weise gezeigt, dass mit einer vervielfachten Bestrahlungsstärke und einer entsprechend verkürzten Beleuchtungszeit ein besserer Effekt erreicht werden kann. Jedoch tritt auch eine Sättigung dieses Effekts mit zunehmender Bestrahlungsstärke auf. Insbesondere bei Dünnschichtsolarmodulen mit Solarzellen auf Basis einer Chalkopyritverbindung kann ab einer Bestrahlungsstärke von ca. 5 kW/m² eine Sättigung hinsichtlich einer weiteren Zunahme der Nennleistung beobachtet werden. Sinnvoll kann es sein, wenn der laminierte Verbund mit einer Bestrahlungsstärke von maximal 15 kW/m² beleuchtet wird, wobei wie erwähnt bereits ab ca. 5 kW/m² eine Sättigung des Anstiegs der Nennleistung auftritt.

Durch die Möglichkeit eine Erhöhung der transient verringerten Nennleistung des Dünnschichtsolarmoduls zu erreichen, indem die Solarzellen mit einer Bestrahlungsstärke von wenigstens 5 kW/m² für einen relativ kurzen Zeitraum von beispielsweise einigen Minuten oder kürzer beleuchtet werden, ermöglicht das erfindungsgemäße Verfahren somit erstmals auch eine Stabilisierung der Nennleistung in der Serienfertigung von Dünnschichtsolarmodulen, bei welcher Taktzeiten im einstelligen Minutenbereich pro Solarmodul üblich sind. Somit können Dünnschichtsolarmodule bereits werksseitig einer Erholung unterzogen und mit einer höheren Nennleistung spezifiziert werden, so dass die Dünnschichtsolarmodule wertiger sind. Zudem kann das elektrische System von Solaranlagen besser und genauer abgestimmt werden.

Im Sinne vorliegender Erfindung beziehen sich die Zeitangaben für die Bestrahlung des Dünnschichtsolarmoduls jeweils auf einen Zeitraum, während dem (bei vollflächiger Bestrahlung) das Dünnschichtsolarmodul vollflächig bestrahlt wird oder während dem (bei abschnittsweiser Bestrahlung) ein Abschnitt bzw. Teil des Dünnschichtsolarmoduls abschnittsweise (d.h. lokal) bestrahlt wird. Auch bei abschnittsweiser Bestrahlung wird das Dünnschichtsolarmodul vollflächig bestrahlt, wobei verschiedene Abschnitte des Solarmoduls zeitlich versetzt bestrahlt werden, beispielsweise indem Lichtquelle und Dünnschichtsolarmodul relativ zueinander bewegt werden, so dass ein insbesondere linienförmiger Lichtstrahl über das Dünnschichtsolarmodul streicht und dabei jeweils Abschnitte des Dünnschichtsolarmoduls bestrahlt.

Für eine in der Praxis ausreichende Erholung der Solarzellen, d.h. um den gewünschten Effekt einer erheblichen Stabilisierung der Nennleistung zu erreichen, kann es, je nach Art des Dünnschichtsolarmoduls und der eingesetzten Bestrahlungsstärke des künstlichen Lichts, vorteilhaft sein, wenn der laminierte Verbund oder zumindest ein Abschnitt des laminierten Verbunds für einen Beleuchtungszeitraum von maximal 10 min (Minuten), maximal 4 min, maximal 2 min, maximal 1 min oder maximal 30 s (Sekunden) beleuchtet wird. Im Sinne obiger Ausführungen beziehen sich diese Angaben bei einer vollflächigen Bestrahlung des Dünnschichtsolarmoduls (alle Solarzellen werden bestrahlt) auf den Gesamtbestrahlungszeitraum des Dünnschichtsolarmoduls oder, alternativ, bei einer abschnittsweisen Bestrahlung des Dünnschichtsolarmoduls (es wird jeweils nur ein Teil der Solarzellen bzw. nicht alle Solarzellen gleichzeitig bestrahlt) auf den Zeitraum, in dem ein jeweiliger Abschnitt des Dünnschichtsolarmoduls lokal bestrahlt wird.

Jedenfalls kann eine zufrieden stellende Erhöhung der transient verringerten Nennleistung von Dünnschichtsolarmodulen zumindest durch Beleuchtung innerhalb weniger Minuten erreicht werden, im Unterschied zur natürlichen Erholung durch Sonnenlicht, die eine Beleuchtung von ca. 48 h bei einer Bestrahlungsstärke 1 kW/m² erfordert, um einen entsprechenden Effekt zu erreichen. Im Übrigen sei darauf hingewiesen, dass zumindest in Nordeuropa eine Bestrahlungsstärke von 1 kW/m² durch Sonneneinstrahlung sehr selten erreicht wird. Insbesondere bei Dünnschichtsolarmodulen mit Dünnschichtsolarzellen mit einer auf einer Chalkopyritverbindung basierenden Halbleiterschicht tritt ab einer Beleuchtungszeit von ca. 2 min eine Sättigung hinsichtlich einer weiteren Zunahme der Nennleistung ein, so dass es von Vorteil sein kann, eine Beleuchtung solcher Module auf einen Beleuchtungszeitraum von 2 min zu begrenzen.

Bei der Herstellung von Dünnschichtsolarmodulen kann eine erfindungsgemäße Beleuchtung beispielsweise unmittelbar im Anschluss an das Laminieren, aber auch zu einem späteren Zeitpunkt, jedoch noch vor Inbetriebnahme der Dünnschichtsolarmodule erfolgen.

Bei einer besonders vorteilhaften Ausgestaltung des erfindungsgemäßen Verfahrens wird der laminierte Verbund bzw. die Solarzellen abschnittsweise (lokal), insbesondere linienförmig, beleuchtet. In einer technisch einfachen Realisierung werden der laminierte Verbund und die Lichtquelle zu diesem Zweck relativ zueinander translatorisch bewegt, wobei insbesondere der laminierte Verbund an einer stationären Lichtquelle vorbei bewegt wird. Der insbesondere linienförmige Lichtstrahl streicht dabei über die Oberfläche des Dünnschichtsolarmoduls hinweg und bestrahlt jeweils lokale Abschnitte des Dünnschichtsolarmoduls mit einer Bestrahlungsstärke von mindestens 5 kW/m². Die Linienbreite (Abmessung senkrecht zu seiner Erstreckung) eines linienförmigen Lichtstrahls liegt beispielsweise im Bereich von 1 bis 10 cm. Vorteilhaft liegt bei diesen Linienbreiten eine Versetzungsgeschwindigkeit des Lichtstrahls auf der Oberfläche des Dünnschichtsolarmoduls (d.h. Verfahrgeschwindigkeit des Dünnschichtsolarmoduls relativ zur Lichtquelle) im Bereich von 0,001 cm/sec bis 10 cm/sec, um durch eine lokale Bestrahlung des Dünnschichtsolarmoduls mit einer Bestrahlungsstärke von mindestens 5 kW/m² und Überstreichen der kompletten Oberfläche des Dünnschichtsolarmoduls die gewünschten Effekte zu erzielen. Die Verfahrgeschwindigkeit ist nicht unabhängig von der Linienbreite. Insbesondere gilt der Zusammenhang, dass eine größere Linienbreite eine schnellere Verfahrgeschwindigkeit ermöglicht und umgekehrt. Durch die linienförmige Ausgestaltung des Lichtstrahls zur Bestrahlung des Dünnschichtsolarmoduls kann eine Zunahme der Nennleistung des Dünnschichtsolarmoduls bewirkt werden, wobei gleichzeitig in vorteilhafter Weise der Energieverbrauch der Lichtquelle auf einen Bruchteil dessen einer vollflächigen Beleuchtung reduziert werden kann. Zudem vereinfacht sich die Apparatur zur Beleuchtung des Dünnschichtsolarmoduls stark. Ferner kann in besonders vorteilhafter Weise auf eine aktive Kühlung des Dünnschichtsolarmoduls während der Beleuchtung verzichtet werden, da bei einer vollflächigen Beleuchtung des Dünnschichtsolarmoduls gegebenenfalls mit einer übermäßigen Erwärmung des kompletten Dünnschichtsolarmoduls zu rechnen ist, die zu einer Beeinträchtigung oder sogar Schädigung des Dünnschichtsolarmoduls führen könnte. Andererseits kann durch die abschnittsweise Beleuchtung des Dünnschichtsolarmoduls eine durchaus erwünschte lokale Erwärmung des Dünnschichtsolarmoduls erreicht werden, die in vorteilhafter Weise zu einer weiteren Verbesserung der Nennleistung beiträgt.

Bei einer weiteren vorteilhaften Ausgestaltung des erfindungsgemäßen Verfahrens wird an die verschalteten Solarzellen während der Beleuchtung eine elektrische Spannung in Sperr- und/oder Stromflussrichtung angelegt, wodurch die transient verringerte Nennleistung noch weiter erhöht bzw. stabilisiert werden kann.

Allgemein kann die Lichtquelle zum Beleuchten des Dünnschichtsolarmoduls so ausgebildet sein, dass sie Licht mit einem frei wählbaren Spektrum aussendet. In vorteilhafter Weise entspricht das Spektrum der Lichtquelle zumindest annähernd dem Spektrum oder zumindest einem Teil des Spektrums des Sonnenlichts (bzw. ist diesem angenähert), wodurch eine besonders effektive Zunahme der transient verringerten Nennleistung des Dünnschichtsolarmoduls erreicht werden kann.

Bei einer weiteren vorteilhaften Ausgestaltung des erfindungsgemäßen Verfahrens wird ein laminierter Verbund mit Verbundscheibenstruktur mit seriell verschalteten Dünnschichtsolarzellen beleuchtet, wobei die Dünnschichtsolarzellen insbesondere über eine Halbleiterschicht verfügen, die aus einer Chalkopyritverbindung, insbesondere Cu(In/Ga) (S/Se)₂, besteht.

Ferner erstreckt sich die Erfindung auf ein Verfahren zur Herstellung eines Dünnschichtsolarmoduls mit einem laminierten Verbund aus zwei durch zumindest eine Klebeschicht miteinander verbundenen Substraten, zwischen denen sich seriell verschaltete Solarzellen befinden, welches die folgenden Schritte umfasst:
- Bereitstellen des laminierten Verbunds;
- Stabilisieren der Nennleistung des Dünnschichtsolarmoduls durch ein wie oben beschriebenes Verfahren, bei dem die Solarzellen mit künstlichem Licht mit einer Bestrahlungsstärke von mindestens 5 kW/m² beleuchtet werden.

Ein solches Verfahren zur Herstellung eines Solarmoduls kann weitere Merkmale des oben beschriebenen Verfahrens zur Erhöhung der transient verringerten Nennleistung eines Dünnschichtsolarmoduls umfassen.

Darüber hinaus erstreckt sich die Erfindung auf die Verwendung von künstlichem Licht zum Beleuchten der Solarzellen eines laminierten Verbunds zur Erhöhung der transient verringerten Nennleistung eines aus dem laminierten Verbund hergestellten Dünnschichtsolarmoduls, wobei die Dünnschichtsolarzellen insbesondere über eine Halbleiterschicht verfügen, die aus einer Chalkopyritverbindung, insbesondere Cu(In/Ga) (S/Se)₂, besteht, wobei die Solarzellen mit Licht einer Bestrahlungsstärke von mindestens 5 kW/m² beleuchtet werden.

### Kurze Beschreibung der Zeichnungen

Die Erfindung wird nun anhand von Ausführungsbeispielen näher erläutert, wobei Bezug auf die beigefügten Figuren genommen wird. Es zeigen in vereinfachter, nicht maßstäblicher Darstellung:
- Fig. 1: eine schematische Darstellung eines beispielhaften Dünnschichtsolarmoduls;
- Fig. 2: eine schematische Darstellung zur Veranschaulichung des Laminierungsprozesses des Dünnschichtsolarmoduls von Fig. 1;

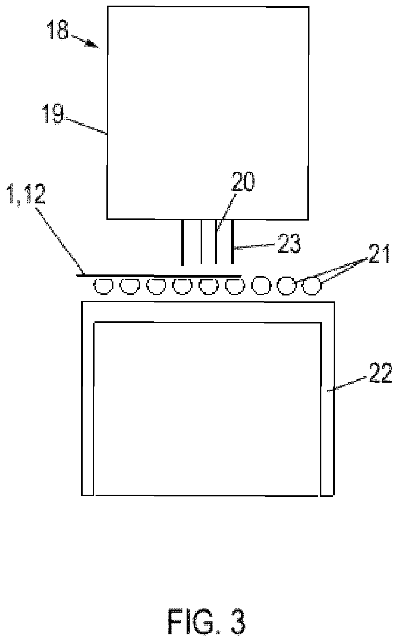

- Fig. 3: eine schematische Darstellung einer Beleuchtungseinrichtung zur Beleuchtung des Dünnschichtsolarmoduls von Fig. 1;
- Fig. 4A-4B: ein Diagramm zur Veranschaulichung des Erholungseffekts bei verschiedenen Lichtintensitäten (Fig. 4A), sowie als Funktion der Zeit bei unveränderter Lichtintensität (Fig. 4B).

### Ausführliche Beschreibung der Zeichnungen

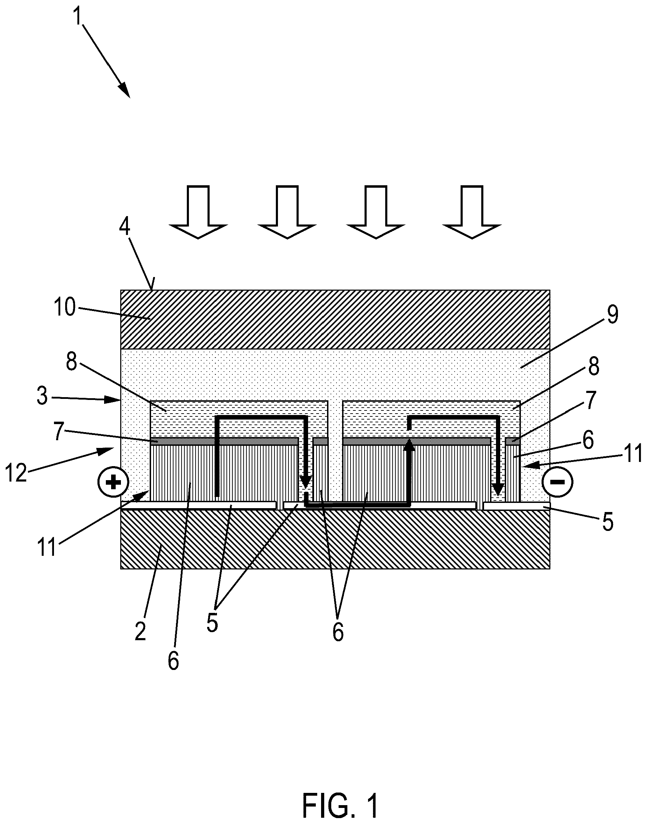

In Figur 1 ist ein insgesamt mit der Bezugszahl 1 bezeichnetes Dünnschichtsolarmodul veranschaulicht. Das Dünnschichtsolarmodul 1 umfasst eine Mehrzahl in integrierter Form seriell verschalteter Solarzellen 11, wobei in Figur 1 zum Zwecke einer einfacheren Darstellung nur zwei Dünnschichtsolarzellen 11 dargestellt sind. Es versteht sich, dass im Dünnschichtsolarmodul 11 eine Vielzahl (beispielsweise ca. 100) Dünnschichtsolarzellen seriell verschaltet sind.

Das Dünnschichtsolarmodul 1 weist eine Verbundscheibenstruktur auf, d.h. es verfügt über ein elektrisch isolierendes erstes Substrat 2 mit einem darauf aufgebrachten Schichtenaufbau 3 aus dünnen Schichten, wobei der Schichtenaufbau 3 auf einer lichteintrittseitigen Oberfläche des ersten Substrats 2 angeordnet ist. Das erste Substrat 2 ist hier beispielsweise als starre Glasplatte mit einer relativ geringen Lichtdurchlässigkeit ausgebildet, wobei gleichermaßen andere elektrisch isolierende Materialien mit gewünschter Festigkeit und inertem Verhalten gegenüber den durchgeführten Prozessschritten eingesetzt werden können.

Der Schichtenaufbau 3 umfasst eine auf der lichteintrittsseitigen Oberfläche des ersten Substrats 2 angeordnete Rückelektrodenschicht 5, die beispielsweise aus einem lichtundurchlässigen Metall wie Molybdän (Mo) besteht und durch Aufdampfen oder magnetfeldunterstützte Kathodenzerstäubung (Sputtern) auf das erste Substrat 2 aufgebracht werden kann. Die Rückelektrodenschicht 5 hat eine Schichtdicke von 300 nm bis 600 nm, welche hier beispielsweise 500 nm beträgt.

Auf der Rückelektrodenschicht 5 ist eine photovoltaisch aktive Halbleiter- bzw. Absorberschicht 6 beispielsweise durch Sputtern abgeschieden, die aus einem mit Metallionen dotierten Halbleiter besteht, dessen Bandabstand vorzugsweise in der Lage ist, einen möglichst großen Anteil des Sonnenlichts zu absorbieren. Die Absorberschicht 6 besteht beispielsweise aus einem p-leitenden Chalkopyrithalbleiter, beispielsweise einer Verbindung der Gruppe
Cu(In/Ga) (S/Se)₂, insbesondere Natrium (Na)-dotiertes Cu(In/Ga) (S/Se)₂. Die Absorberschicht 6 hat eine Schichtdicke, die beispielsweise im Bereich von 1-5 µm liegt und insbesondere ca. 2 µm beträgt. Zwischen der Rückelektrodenschicht 5 und der Absorberschicht 6 kann eine Barrierenschicht aus beispielsweise Siliziumnitrid, die als Diffusionsbarriere für die als Dotierstoff dienenden Metallionen der Absorberschicht wirkt, vorgesehen sein, was in Figur 1 nicht näher dargestellt ist. Eine Umsetzung der verschiedenen Metalle zu dem Halbleitermaterial erfolgt durch Erwärmen in einem Ofen (RTP = Rapid Thermal Processing).

Auf die Absorberschicht 6 ist eine Pufferschicht 7 abgeschieden, die hier beispielsweise aus einer Einzellage Cadmiumsulfid (CdS) und einer Einzellage aus intrinsischem Zinkoxid (i-ZnO) besteht, was in Figur 1 nicht näher dargestellt ist.

Auf die Pufferschicht 7 ist eine Frontelektrodenschicht 8 beispielsweise durch Sputtern aufgebracht. Die Frontelektrodenschicht 8 ist für Strahlung im sichtbaren Spektralbereich transparent ("Fensterelektrode"), so dass das einstrahlende Sonnenlicht (in Fig. 1 durch die vier parallelen Pfeile veranschaulicht) nur gering geschwächt wird. Die Frontelektrodenschicht 8 basiert beispielsweise auf einem dotierten Metalloxid, beispielsweise n-leitendes Aluminium (Al)-dotiertes Zinkoxid (ZnO). Eine solche Frontelektrodenschicht 8 wird allgemein als TCO-Schicht (TCO = Transparent Conductive Oxide) bezeichnet. Die Schichtdicke der Frontelektrodenschicht 8 beträgt beispielsweise ca. 500 nm.

Durch die Frontelektrodenschicht 8 wird gemeinsam mit der Pufferschicht 7 und der Absorberschicht 6 ein Heteroübergang (d.h. Abfolge von Schichten vom entgegen gesetzten Leitungstyp) gebildet. Dabei kann die Pufferschicht 7 eine elektronische Anpassung zwischen dem halbleitenden Material der Absorberschicht 6 und dem Material der Frontelektrodenschicht 8 bewirken.

Die verschiedenen Schichten des Schichtenaufbaus 3 auf dem ersten Substrat 2 sind unter Einsatz einer geeigneten Strukturierungstechnologie wie Laserschreiben strukturiert, wodurch sich die integriert seriell verschalteten Dünnschichtsolarzellen 11 ergeben. Eine solche Strukturierung umfasst für jede Solarzelle typischer Weise drei Strukturierungsschritte (P1, P2, P3), bei denen zunächst die Rückelektrodenschicht 5 (P1), anschließend die Halbleiterschicht 6 (P2), und als letztes die Frontelektrodenschicht 8 und die Halbleiterschicht 6 (P3) strukturiert werden. Eine solche Strukturierung ist dem Fachmann an sich bekannt, so dass hier nicht näher darauf eingegangen werden muss.

In dem hier dargestellten Beispiel sind sowohl der resultierende positive Spannungsanschluss (+) als auch der resultierende negative Spannungsanschluss (-) des Dünnschichtsolarmoduls 1 über die Rückelektrodenschicht 5 geführt und dort elektrisch kontaktiert. Durch Beleuchtung der Dünnschichtsolarzellen 11 wird an den beiden Spannungsanschlüssen eine elektrische Spannung erzeugt. Ein resultierender Strompfad ist in Fig. 1 durch die seriellen Pfeile veranschaulicht.

Zum Schutz vor Umwelteinflüssen ist auf der Frontelektrodenschicht 8 eine (Kunststoff-)Klebeschicht 9 aufgebracht, die zur Verkapselung des Schichtenaufbaus 3 dient. Zudem umfasst der Schichtenaufbau 3 als vorderseitige Deckschicht ein für Sonnenlicht transparentes zweites Substrat 10, das beispielsweise in Form einer Glasplatte aus extraweißem Glas mit geringem Eisengehalt ausgebildet ist, wobei gleichermaßen andere elektrisch isolierende Materialien mit gewünschter Festigkeit und inertem Verhalten gegenüber den durchgeführten Prozessschritten eingesetzt werden können. Das zweite Substrat 10 dient zur Versiegelung und mechanischen Schutz des Schichtenaufbaus 3. Über eine vorderseitige Oberfläche 4 des zweiten Substrats 10 kann das Dünnschichtsolarmodul beleuchtet werden, um elektrische Energie zu erzeugen.

Die beiden Substrate 2, 10 sind durch die Klebeschicht 9 fest miteinander verbunden ("laminiert"), wobei die Klebeschicht 9 hier beispielsweise als thermoplastische Klebeschicht ausgebildet ist, die durch Erwärmen plastisch verformbar wird und beim Abkühlen die beiden Substrate 2 und 10 fest miteinander verbindet. Die Klebeschicht 9 besteht hier beispielsweise aus PVB. Die beiden Substrate 2, 10 mit den in die Klebeschicht 9 eingebetteten Dünnschichtsolarzellen 11 formen gemeinsam einen laminierten Verbund 12. Die Größe der rechteckförmigen vorderseitigen Oberfläche 4 des Dünnschichtsolarmoduls 1 beträgt hier beispielsweise 1,6 x 0,7 m².

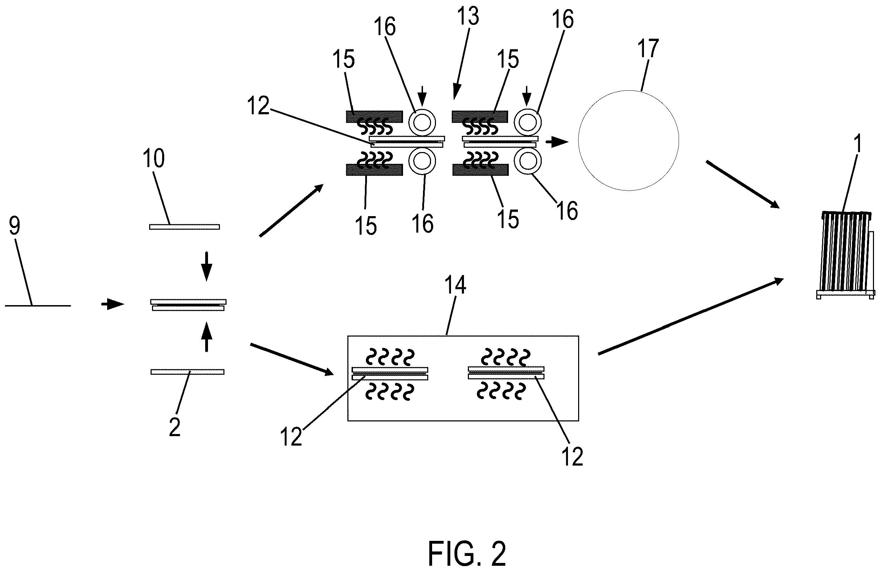

Bei der Herstellung des Dünnschichtsolarmoduls 1 erfolgt eine Laminierung, bei welcher die beiden Substrate 2, 10 mit den dazwischen angeordneten Dünnschichtsolarzellen 11 durch die Klebeschicht 9 verklebt werden. In der Serienfertigung werden hierfür gewöhnlich zwei verschiedene Laminierungsverfahren eingesetzt, die in Fig. 2 näher veranschaulicht sind.

In beiden Laminierungsverfahren werden das erste Substrat 2 mit den aufgebrachten und strukturierten Dünnschichtsolarzellen 11 und das zweite Substrat 10 und eine als Klebeschicht 9 dienende Folie übereinander liegend angeordnet. Dann wird dieser Schichtenaufbau in einen Rollenlaminator 13 eingebracht, bei dem über Heizelemente 15 geheizt und durch Rollen 16 ein Druck ausgeübt wird, so dass die PVB-Folie schmilzt und nach Abkühlen der laminierte Verbund 12 entsteht. Weiterhin erfolgt eine Behandlung in einem Autoklaven 17. Alternativ kann der Schichtenaufbau in einen Vakuumlaminator 14 eingebracht werden, bei dem ebenfalls über Heizelemente erwärmt und durch eine Membran (nicht gezeigt) ein Druck ausgeübt wird, wodurch die PVB-Folie schmilzt und der laminierte Verbund 12 entsteht. Durch das Laminieren können in den Dünnschichtsolarzellen 11 reversible (ausheilende) Defekte auftreten, welche die Nennleistung des Dünnschichtsolarmoduls 1 zeitweilig herabsetzen.

Um im Rahmen der Serienfertigung des Dünnschichtsolarmoduls 1 eine schnelle und effiziente Erholung des Wirkungsgrads, d.h. ein Ausheilen der durch das Laminieren verursachten Defekte in der Halbleiterschicht der Dünnschichtsolarzellen 11 zu erreichen, wird der laminierte Verbund 12 bzw. das Dünnschichtsolarmodul 1 einer Beleuchtung mit künstlichem Licht in einer speziellen Beleuchtungseinrichtung 18 unterzogen. Im Weiteren wird von der Beleuchtung des Dünnschichtsolarmoduls 1 gesprochen, wobei es sich versteht, dass gleichermaßen auch der laminierte Verbund 12, bei dem es sich auch um ein Zwischenprodukt bei der Herstellung des Dünnschichtsolarmoduls 1 handeln kann (welcher beispielsweise noch über keine Spannungsanschlüsse verfügt), beleuchtet werden kann.

Die Beleuchtungseinrichtung 18 enthält mindestens eine künstliche Lichtquelle 19, beispielsweise eine Halogenlampe, vorzugsweise mit einem an das Spektrum des Sonnenlichts angenäherten Spektrum, welche einen Lichtstrahl 20 zur Beleuchtung der Dünnschichtsolarzellen 11 erzeugt. Durch eine Abschattungseinrichtung bzw. Blende 23 wird ein sich über eine vollständige Abmessung (Breite oder Länge) der rechteckförmigen, vorderseitigen Oberfläche 4 des zweiten Substrats 10 erstreckender, streifen- bzw. linienförmiger Lichtstrahl 20 erzeugt. Der Lichtstrahl 20 weist hier auf der Oberfläche 4 des zweiten Substrats 10 beispielsweise eine Breite von ca. 1,5 cm auf, wobei der Lichtstrahl 20 zumindest annähernd senkrecht auf die Oberfläche 4 des zweiten Substrats 10 auftrifft. Wie in der Beschreibungseinleitung angegeben, kann die Linienbreite allgemein beispielsweise im Bereich von 1 bis 10 cm liegen.

Das Dünnschichtsolarmodul 1 wird durch angetriebene Walzen 11 auf einem Gestell 22 translatorisch (unidirektional) unterhalb der stationären Lichtquelle 19 vorbei geführt, wobei der feststehende linienförmige Lichtstrahl 20 über die Oberfläche 4 des zweiten Substrats 10 streicht und das Dünnschichtsolarmodul 1 abschnittsweise beleuchtet. Die Breite des Lichtstrahls 20 bemisst sich hier in Bewegungsrichtung des Dünnschichtsolarmoduls 1. Wie bereits erwähnt, erstreckt sich der Lichtstrahl 1 senkrecht zur Bewegungsrichtung vollständig über eine zu den Rändern parallele Abmessung des Dünnschichtsolarmoduls 1, hier beispielsweise über dessen Breite. Dabei wird das Dünnschichtsolarmodul 1 relativ zum Lichtstrahl 20 bewegt, so dass das Dünnschichtsolarmodul 1 bzw. die Dünnschichtsolarzellen 11 mit einer Bestrahlungsstärke von mindestens 5 kW/m² beleuchtet werden. Die Lichtquelle 19 weist eine entsprechend hohe Lichtintensität auf, der Abstand zwischen der Lichtquelle 19 und dem Dünnschichtsolarmodul 19 ist in entsprechender Weise eingestellt. Die Verfahrgeschwindigkeit des Dünnschichtsolarmoduls 1 relativ zur Lichtquelle 19 liegt beispielsweise im Bereich von 0,001 cm/sec bis 10 cm/sec, wobei die Verfahrgeschwindigkeit generell von der Linienbreite des Lichtstrahls abhängt.

In der nachfolgenden Tabelle 1 ist die Verringerung des Wirkungsgrads (Nennleistung) eines in verschiedener Weise behandelten Dünnschichtsolarmoduls 1 mit einer auf einer Chalkopyritverbindung basierenden Halbleiterschicht angegeben.

**Tabelle 1**

| | | Δη (%) |
|---|---|---|
| # 1 | Nach Laminieren | -11,8 |
| | | |
| # 2 | Linienbeleuchtung 8 kW/m², 10 min | -2,4 |
| # 3 | Linienbeleuchtung 5 kW/m², 10 min | -2,2 |
| # 4 | Lichtalterung 1 kW/m², 48 h | -0,6 |

| | | |
|---|---|---|
| In Tabelle 1 bezieht sich Δη (%) auf den prozentualen Unterschied im Wirkungsgrad des Dünnschichtsolarmoduls, bezogen auf den Wirkungsgrad der verschalteten Solarzellen vor dem Laminieren. #1 betrifft eine Messung des Wirkungsgrads bei einem Dünnschichtsolarmodul unmittelbar nach dem Laminieren (unverkapselt), wobei das Dünnschichtsolarmodul weder einer Wärmebehandlung noch einer speziellen Beleuchtung mit künstlichem Licht ausgesetzt wurde. Demnach tritt durch das Laminieren eine prozentuale Verminderung des Wirkungsgrads um -11,8% auf, so dass die Nennleistung eines solchen Dünnschichtsolarmoduls ab Werk geringer ist als die tatsächliche Nennleistung, die sich im Laufe der Zeit durch Ausheilen der Defekte einstellt. #2 betrifft eine Messung des Wirkungsgrads bei einem Dünnschichtsolarmodul nach dem Laminieren, wobei eine Beleuchtung mit einem linienförmigen Lichtstrahl wie in Beleuchtungseinrichtung 18 mit einer Bestrahlungsstärke von 8 kW/m² für einen Zeitraum von 10 min durchgeführt wurde. Demnach wird durch die Beleuchtung eine deutliche Erholung des Wirkungsgrads erreicht, wobei die prozentuale Verminderung des Wirkungsgrads nach der Beleuchtung nur noch -2,6% beträgt. #3 betrifft eine Messung des Wirkungsgrads bei einem wie in #2 behandelten Dünnschichtsolarmodul, jedoch mit einer Bestrahlungsstärke von 5 kW/m². Auch in diesem Fall wird eine deutliche Erholung des Wirkungsgrads erreicht, wobei die prozentuale Verminderung des Wirkungsgrads nach der Beleuchtung -2,4% beträgt und somit in der gleichen Größenordnung liegt wie bei #2. Schließlich betrifft #4 eine Messung des Wirkungsgrads bei einem Dünnschichtsolarmodul nach dem Laminieren, wobei eine so genannte Lichtalterung (Light Soaking) mit einer vollflächigen Beleuchtung mit einer Bestrahlungsstärke von 1 kW/m² für einen Zeitraum von 48 Stunden durchgeführt wurde. Demnach wird auch durch die Lichtalterung eine Erholung des Wirkungsgrads erreicht, wobei die prozentuale Verminderung des Wirkungsgrads nach der Lichtalterung -0,6% beträgt. In der Serienfertigung mit Taktzyklen im einstelligen Minutenbereich kann eine solche Lichtalterung aufgrund der langen Bestrahlungszeit nicht durchgeführt werden. | | |

Somit wird erkennbar, dass durch die erfindungsgemäße Beleuchtung des Dünnschichtsolarmoduls mit einem linienförmigen Lichtstrahl bei 5 kW/m² oder 8 kW/m² für einen vergleichsweise kurzen Beleuchtungszeitraum von 10 min eine deutliche Erhöhung des transient verringerten Wirkungsgrads erreicht werden kann, welcher sich nicht wesentlich vom Wirkungsgrad nach einer Lichtalterung für 48 Stunden unterscheidet.

In der nachfolgenden Tabelle 2 sind die Ergebnisse für ein weiteres Dünnschichtsolarmodul mit einer auf einer Chalkopyritverbindung (CIS) basierenden Halbleiterschicht angegeben.

**Tabelle 2**

| | | Δη (%) |
|---|---|---|
| # 1 | nach Laminieren | -16,3 |
| # 3 | Linienbeleuchtung 10 kW/m², 1 min | -5,6 |
| # 5 | Lichtalterung 1 kW/m², 48 h | -4,0 |

| | | |
|---|---|---|
| In Tabelle 2 bezieht sich Δη (%) wiederum auf den prozentualen Unterschied im Wirkungsgrad des Dünnschichtsolarmoduls, bezogen auf den Wirkungsgrad der verschalteten Solarzellen vor dem Laminieren. #1 betrifft eine Messung des Wirkungsgrads unmittelbar nach dem Laminieren (unverkapselt) ohne Wärmebehandlung oder spezielle Beleuchtung mit künstlichem Licht. Für dieses Dünnschichtsolarmodul tritt eine prozentuale Verminderung des Wirkungsgrads um -16,3% auf. #2 betrifft eine Messung des Wirkungsgrads bei einem Dünnschichtsolarmodul nach dem Laminieren, wobei eine Beleuchtung mit einem linienförmigen Lichtstrahl mit einer Bestrahlungsstärke von 10 kW/m² für einen Zeitraum von 1 min durchgeführt wurde. Demnach wird durch die Beleuchtung eine deutliche Erholung des Wirkungsgrads erreicht, wobei die prozentuale Verminderung des Wirkungsgrads nach der Beleuchtung nur noch -5,6% beträgt. #3 betrifft eine Messung des Wirkungsgrads bei einem Dünnschichtsolarmodul nach dem Laminieren, wobei eine Lichtalterung mit einer vollflächigen Beleuchtung mit einer Bestrahlungsstärke von 1 kW/m² für einen Zeitraum von 48 Stunden durchgeführt wurde, wobei die prozentuale Verminderung des Wirkungsgrads nach der Lichtalterung -4,0% beträgt. | | |

Wie sich aus den Daten von Tabelle 2 ergibt, kann durch die Beleuchtung mit hoher Lichtintensität eine Verringerung des Leistungsverlusts (d.h. Zunahme der Nennleistung) um 10,7% erreicht werden, wobei im Vergleich hierzu durch die Lichtalterung nur eine geringfügige weitere Zunahme um 1,6% erzielt werden kann. Der durch die Laminierung erzeugte Leistungsverlust kann somit erheblich verringert werden. Erkennbar ist auch, dass die Zeitersparnis im Vergleich zur 48-stündigen Lichtalterung einem Faktor 2880 entspricht, obgleich die Bestrahlungsstärke nur um einen Faktor 10 erhöht wurde und der Energieeinsatz um das ca. 20-fache geringer war, wie nachfolgendes Rechenbeispiel zeigt.

Beim Einsatz von Halogenlampen wird bei einem rechteckförmigen Dünnschichtsolarmodul mit einer Größe von 1,6 x 0,7 m² (Länge x Breite) eine vollflächige Ausleuchtung mit einer Bestrahlungsstärke von 1 kW/m² eine elektrische Anschlussleistung von beispielsweise ca. 40,5 kW benötigt. Würde eine vollflächige Ausleuchtung bei 10 kW/m² vorgesehen sein, so erhöhte sich die elektrische Anschlussleistung typischer Weise auf den 5 bis 10-fachen Wert, würde also ca. 202,5 bis 405 kW betragen, was in der Praxis mit erheblichen Kosten verbunden ist. Andererseits beträgt die elektrische Anschlussleistung bei einer linienförmigen Beleuchtung des Dünnschichtsolarmoduls mit einer Breite von 0,7 m und einer Bestrahlungsstärke von 10 kW/m² ca. 2,1 kW. Somit liegt die Energieersparnis durch das linienförmige Beleuchten bei dem ca. 20-fachen im Vergleich zu einer vollflächigen Beleuchtung bei 1 kW/m² und bei dem ca. 100 bis 200-fachen im Vergleich zu einer vollflächigen Beleuchtung bei 10 kW/m².

Durch die linienförmige Beleuchtung des Dünnschichtsolarmoduls kann somit in erheblichem Umfang Energie eingespart werden, insbesondere da eine vollflächige Beleuchtung in aller Regel eine aktive Kühlung des Dünnschichtsolarmoduls erfordern würde.

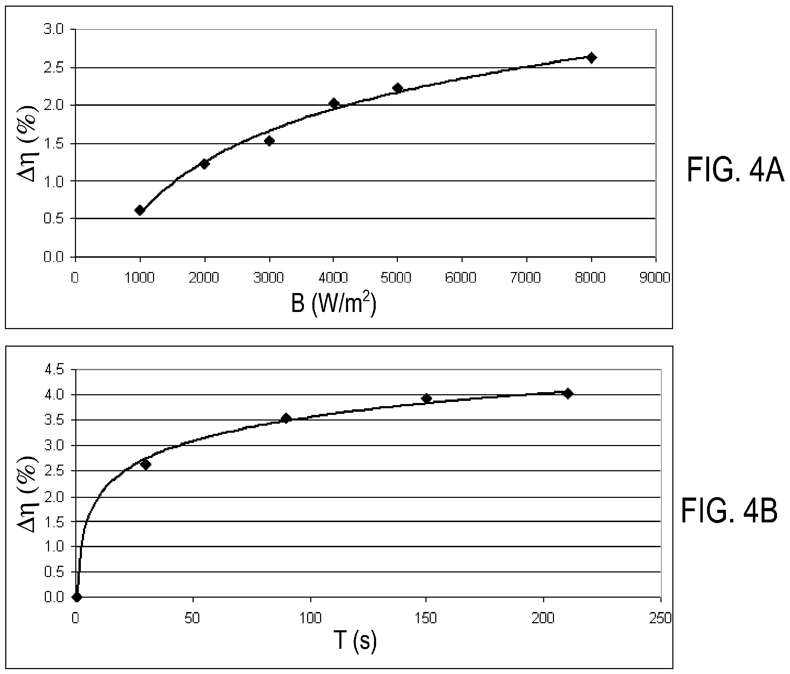

In Fig. 4A ist ein Diagramm zur Veranschaulichung des Erholungseffekts bei verschiedenen Lichtintensitäten bzw. Bestrahlungsstärken B (W/m²) gezeigt. Dabei wurde ein Dünnschichtsolarmodul mit einer auf einer Chalkopyritverbindung basierenden Halbleiterschicht für einen Zeitraum von 30 s mit einem linienförmigen Lichtstrahl beleuchtet, wobei das Dünnschichtsolarmodul relativ zum Lichtstrahl bewegt wurde. Angegeben ist der Betrag des prozentualen Unterschieds im Wirkungsgrad des Dünnschichtsolarmoduls, bezogen auf den Wirkungsgrad der verschalteten Solarzellen vor dem Laminieren, Δη (%), für verschiedene Bestrahlungsstärken. Erkennbar steigt die prozentuale Änderung des Wirkungsgrads zunächst stark an, bis bei ca. 5 kW/m² eine Sättigung eintritt.

In Fig. 4B ist ein Diagramm zur Veranschaulichung des Erholungseffekts bei verschiedenen Beleuchtungszeiten T(s) gezeigt. Dabei wurde ein Dünnschichtsolarmodul mit einer auf einer Chalkopyritverbindung basierenden Halbleiterschicht mit einem linienförmigen Lichtstrahl und einer Bestrahlungsstärke von 8 kW/m² beleuchtet, wobei das Dünnschichtsolarmodul relativ zum Lichtstrahl bewegt wurde. Angegeben ist der Betrag des prozentualen Unterschieds im Wirkungsgrad des Dünnschichtsolarmoduls, bezogen auf den Wirkungsgrad der verschalteten Solarzellen vor dem Laminieren, Δη (%), für verschiedene Beleuchtungsdauern. Erkennbar wird schon nach kurzer Zeit ein großer Hub erreicht, der danach in etwa logarithmisch abflacht. Bei ca. 2 min Beleuchtungsdauer tritt eine Sättigung ein.

Die vorliegende Erfindung stellt ein Verfahren zur Stabilisierung der Nennleistung eines Dünnschichtsolarmoduls zur Verfügung, das in der industriellen Serienfertigung von Dünnschichtsolarmodulen mit Taktzyklen im einstelligen Minutenbereich zum zumindest weitgehenden Ausheilen von durch das Laminieren erzeugten Defekten eingesetzt werden kann.

### Bezugszeichenliste

- 1: Dünnschichtsolarmodul
- 2: erstes Substrat
- 3: Schichtenaufbau
- 4: Oberfläche
- 5: Rückelektrodenschicht
- 6: Halbleiterschicht
- 7: Pufferschicht
- 8: Frontelektrodenschicht
- 9: Klebeschicht
- 10: zweites Substrat
- 11: Dünnschichtsolarzelle
- 12: Verbund
- 13: Rollenlaminator
- 14: Vakuumlaminator
- 15: Heizelement
- 16: Rolle
- 17: Autoklave
- 18: Beleuchtungseinrichtung
- 19: Lichtquelle
- 20: Lichtstrahl
- 21: Walze
- 22: Gestell
- 23: Blende

## Patentansprüche

1. Verfahren zur Stabilisierung der Nennleistung eines Dünnschichtsolarmoduls (1) mit einem laminierten Verbund (12) aus zwei durch zumindest eine Klebeschicht (9) miteinander verbundenen Substraten (2, 10), zwischen denen sich seriell verschaltete Solarzellen (11) befinden, wobei der laminierte Verbund (12) eine Verbundscheibenstruktur mit seriell verschalteten Dünnschichtsolarzellen aufweist, wobei die Dünnschichtsolarzellen über eine Halbleiterschicht verfügen, die aus einer Chalkopyritverbindung, insbesondere Cu(In/Ga)(S/Se)₂, besteht, bei welchem die Solarzellen (11) mit künstlichem Licht mit einer Bestrahlungsstärke von mindestens 5 kW/m² beleuchtet werden.

2. Verfahren nach Anspruch 1, bei welchem zumindest ein Abschnitt des laminierten Verbunds (12) während eines Beleuchtungszeitraums von maximal 10 min, maximal 4 min, maximal 2 min, maximal 1 min oder maximal 30 s beleuchtet wird.

3. Verfahren nach einem der Ansprüche 1 oder 2, bei welchem der laminierte Verbund (12) mit einer Bestrahlungsstärke von maximal 15 kW/m² beleuchtet wird.

4. Verfahren nach einem der Ansprüche 1 bis 3, bei welchem der laminierte Verbund (12) abschnittsweise, insbesondere linienförmig, beleuchtet wird.

5. Verfahren nach Anspruch 4, bei welchem der laminierte Verbund (12) und eine künstliche Lichtquelle (19) zur Erzeugung des künstlichen Lichts zur abschnittsweisen Beleuchtung relativ zueinander translatorisch bewegt werden.

6. Verfahren nach Anspruch 5, bei welchem der laminierte Verbund (12) an einer stationären Lichtquelle (19) vorbei bewegt wird.

7. Verfahren nach einem der Ansprüche 1 bis 6, bei welchem an die verschalteten Solarzellen (11) während der Beleuchtung eine elektrische Spannung in Sperr- und/oder Stromflussrichtung angelegt wird.

8. Verfahren nach einem der Ansprüche 1 bis 7, bei welchem das Spektrum des künstlichen Lichts zumindest annähernd zumindest einem Teil des Spektrums des Sonnenlichts entspricht.

9. Verfahren zur Herstellung eines Dünnschichtsolarmoduls (1) mit einem laminierten Verbund (12) aus zwei durch zumindest eine Klebeschicht (9) miteinander verbundenen Substraten (2, 10), zwischen denen sich seriell verschaltete Solarzellen (11) befinden, wobei der laminierte Verbund (12) eine Verbundscheibenstruktur mit seriell verschalteten Dünnschichtsolarzellen aufweist, wobei die Dünnschichtsolarzellen über eine Halbleiterschicht verfügen, die aus einer Chalkopyritverbindung, insbesondere Cu(In/Ga)(S/Se)₂, besteht, welches die folgenden Schritte umfasst:
- Bereitstellen des laminierten Verbunds (12);
- Stabilisieren der Nennleistung des Dünnschichtsolarmoduls (1) durch ein Verfahren nach einem der Ansprüche 1 bis 8.

10. Verwendung von künstlichem Licht zum Beleuchten der Solarzellen (11) eines laminierten Verbunds (12) eines Dünnschichtsolarmoduls (1) zur Stabilisierung der Nennleistung des Dünnschichtsolarmoduls, wobei die Dünnschichtsolarzellen über eine Halbleiterschicht verfügen, die aus einer Chalkopyritverbindung, insbesondere Cu(In/Ga)(S/Se)₂, besteht, wobei die Solarzellen mit Licht einer Bestrahlungsstärke von mindestens 5 kW/m² beleuchtet werden.

## Claims

1. Method for stabilizing the nominal output of a thin-film solar module (1) with a laminated composite (12) of two substrates (2, 10) connected to each other by at least one adhesive layer (9), between which substrates solar cells (11) connected in series are situated, wherein the laminated composite (12) has a laminated pane structure with thin-film solar cells connected in series, wherein the thin-film solar cells have a semiconductor layer made of a chalcopyrite compound, in particular Cu(In/Ga)(S/Se)₂, wherein the solar cells (11) are illuminated with artificial light with an irradiance of at least 5 kW/m².

2. Method according to claim 1, wherein at least one section of the laminated composite (12) is illuminated for an illumination period of a maximum of 10 min, a maximum of 4 min, a maximum of 2 min, a maximum of 1 min, or a maximum of 30 s.

3. Method according to one of claims 1 or 2, wherein the laminated composite (12) is illuminated with an irradiance of a maximum of 15 kW/m².

4. Method according to one of claims 1 through 3, wherein the laminated composite (12) is illuminated section by section, in particular linearly.

5. Method according to claim 4, wherein the laminated composite (12) and an artificial light source (19) for generating the artificial light for the section by section Illumination are moved translatorily relative to each other.

6. Method according to claim 5, wherein the laminated composite (12) is moved past a stationary light source (19).

7. Method according to one of claims 1 through 6, wherein, during the illumination, a forward and/or reverse biased electric voltage is applied to the connected solar cells (11).

8. Method according to one of claims 1 through 7, wherein the spectrum of the artificial light corresponds at least approx. to at least one part of the spectrum of sunlight.

9. Method for producing a thin-film solar module (1) with a laminated composite (12) of two substrates (2, 10) connected to each other by at least one adhesive layer (9), between which substrates solar cells connected in series (11) are situated, wherein the laminated composite (12) has a laminated pane structure with thin-film solar cells connected in series, wherein the thin-film solar cells have a semiconductor layer made of a chalcopyrite compound, in particular Cu(In/Ga)(S/Se)₂, which comprises the following steps:
- providing the laminated composite (12);
- stabilizing the nominal output of the thin-film solar module (1) by a method according to one of claims 1 through 8.

10. Use of artificial light for illumination of solar cells (11) of a laminated composite (12) of a thin-film solar module (1) for stabilization of the nominal output of the thin-film solar module, wherein the thin-film solar cells have a semiconductor layer made of a chalcopyrite compound, in particular Cu(In/Ga)(S/Se)₂, wherein the solar cells are illuminated with light with an irradiance of at least 5 kW/m².

## Revendications

1. Procédure pour la stabilisation de la puissance nominale d'un module solaire à couches minces (1) avec un composite laminé (12) composé de deux substrats (2, 10) reliés ensemble par au moins une couche adhésive (9), entre lesquelles se trouvent des cellules solaires reliées en série (11), où le composite laminé (12) possède une structure stratifiée avec des cellules solaires à couches minces reliées en série, où les cellules solaires à couches minces disposent d'une couche conductrice qui consiste en un composé de chalcopyrite, en particulier de Cu(In/Ga)(S/Se)₂, où les cellules solaires (11) sont illuminées par une lumière artificielle avec une intensité d'irradiation d'au moins 5 kW/m².

2. Procédure selon la revendication 1, où au moins une section du composite laminé (12) est illuminée pendant une période d'illumination de 10 minutes au maximum, de 4 minutes au maximum, de 2 minutes au maximum d'une minutes au maximum ou de 30 secondes au maximum.

3. Procédure selon l'une des revendications 1 ou 2, où au moins le composite laminé (12) est illuminé avec une intensité d'irradiation de jusqu'à 15 kW/m².

4. Procédure selon l'une des revendications 1 à 3, où le composite laminé (12) est illuminé par sections, en particulier linéaire.

5. Procédure selon la revendication 4, où le composite laminé (12) et une source de lumière artificielle (19) pour la création d'une lumière artificielle pour l'illumination par sections sont déplacés en translation l'un par rapport à l'autre.

6. Procédure selon la revendication 5, où le composite laminé (12) est déplacé devant une source de lumière stationnaire (19).

7. Procédure selon l'une des revendications 1 à 6, où lors de l'illumination une tension électrique est appliquée aux cellules solaires connectées (11) polarisée dans le sens inverse et/ou dans le sens de circulation du courant.

8. Procédure selon l'une des revendications 1 à 7, où le spectre de la lumière artificielle se rapproche au moins à au moins une partie du spectre de la lumière du soleil.

9. Procédure pour la production d'un module solaire mince (1) avec un composite laminé (12) composé de deux substrats (2, 10) reliés ensemble par au moins une couche adhésive (9), entre lesquelles se trouvent des cellules solaires reliées en série (11), où le composite laminé (12) possède une structure de vitres composites avec des cellules solaires à couches minces reliées en série, où le composite laminé (12) possède une structure stratifiée avec des cellules solaires à couches minces reliées en série, où les cellules solaires à couches minces disposent d'une couche conductrice qui consiste en un composé de chalcopyrite, en particulier de Cu(In/Ga)(S/Se)₂, qui comprend les étapes suivantes:
- fourniture du composite laminé (12);
- stabilisation de la puissance nominale du module solaire à couches minces (1) grâce à une procédure selon l'une des revendications 1 à 8.

10. Utilisation de lumière artificielle pour l'illumination de cellules solaires (11) d'un composite laminé (12) d'un module solaire à couches minces (1) pour la stabilisation de la puissance nominale du module solaire à couches minces (1) où les cellules solaires à couches minces disposent d'une couche semi-conductrice, qui consiste en un composé de chalcopyrite, en particulier de Cu(In/Ga)(S/Se)₂, où les cellules solaires sont illuminées avec une lumière dont la puissance d'irradiation est de 5 kW/m².
